# EUROPEAN PATENT SPECIFICATION

(11) **EP 2 824 448 B1**
(45) Date of publication and mention of the grant of the patent: **14.12.2016**
(21) Application number: 13180033.6
(22) Date of filing: 12.08.2013
(51) Int. Cl.: G01N 23/20, H01J 37/20

(54) **Sample holder for transmission Kikuchi diffraction in SEM**
Probenhalter für Elektronenrückstreuungsbeugung
Porte-échantillon pour diffraction d'électrons rétrodiffusés

(30) Priority: 08.07.2013 EP 13175476
(43) Date of publication of application: 14.01.2015
(73) Proprietor: Bruker Nano GmbH, 12489 Berlin (DE)
(72) Inventor: Goran, Daniel Radu, 10555 Berlin (DE); Hahn, Waldemar, 12435 Berlin (DE)
(74) Representative: Gulde & Partner

(56) References cited:
- DE-A1- 3 628 170
- JP-A- S5 024 072
- JP-A- H10 199 461
- JP-A- 2005 293 865
- JP-U- S6 148 647
- PATRICK W. TRIMBY: "Orientation mapping of nanostructured materials using transmission Kikuchi diffraction in the scanning electron microscope", ULTRAMICROSCOPY, vol. 120, 1 September 2012 (2012-09-01), pages 16-24, XP055116323, ISSN: 0304-3991, DOI: 10.1016/j.ultramic.2012.06.004

## Description

The present invention refers to a sample holder for positioning a sample in an electron microscope (EM), which is configured to perform transmission Kikuchi diffraction (TKD) measurements. Moreover, the present invention refers to an electron microscope (EM) comprising the sample holder according to the invention, wherein the EM is configured to perform transmission Kikuchi diffraction (TKD) measurements.

### TECHNOLOGICAL BACKGROUND AND PRIOR ART

Electron backscatter diffraction (EBSD), which is also known as backscatter Kikuchi diffraction (BKD), is a well known technique of electron microscopes (EM) to measure crystal orientations. It is applicable to any crystalline material (in theory) and provides absolute crystal orientation with sub-micron spatial resolution. Moreover it is a useful tool for discriminating between phases.

Thereby backscattered electrons strike a phosphor screen of an EBSD detector and produce light, which is detected by a CCD (charge-coupled device) camera of the EBSD detector, digitised and sent to a computer. The biggest advantages of EBSD analysis are that a correlation between local texture and microstructure can be distinguished as well as a grain boundary and a grain size analysis can be done.

Signal yield and distribution are a function of working distance (WD), sample-screen distance (DD), acceleration voltage, sample tilt and the density of the material. The working distance is the length the electron beam travels inside the SEM chamber, i.e. between the sample and the surface of a column (comprising the electron lenses of the EM) which is closest to the sample, especially between a pole piece (of an electron lens) of the EM and the surface of a sample. The sample-screen distance is the distance between the sample (point source) and the phosphor screen. An in-situ screen positioning provides high flexibility in WD and DD whereby the EBSD signal can be optimized for each measurement.

Nowadays EBSD detectors of EMs have also been used to perform measurements with a technique that is called transmission Kikuchi diffraction (TKD), also known as transmission electron backscatter diffraction (t-EBSD). To perform TKD measurements, samples are prepared as for transmission electron microscopy (TEM). Thus the samples are electron transparent. The samples are mounted to be horizontal or tilted by slight a negative angle (e.g. 10 to 20 degrees) from the horizontal that is in the opposite way round as known for EBSD. The sample is positioned above the phosphor screen of the EBSD detector. Therefore the electron beam hits the upper side of the sample and transmitted electrons are detected by the EBSD detector. Thus a diffraction pattern from the lower surface (exit surface) of the electron transparent sample is obtained. Investigations proved that TKD improves the lateral spatial resolution by an order of magnitude compared to EBSD.

Up till now sample holders for TKD have been improvisational and are disadvantageous in terms of handling thin (very fragile) samples and have a negative influence on the quality of measurements.

One known way of fixing a sample or a sample carrier inside an EM is to adhere it to a sample stub. This way of fixing is relatively time consuming and intensifies the C contamination phenomenon which is detrimental to the measurements. Moreover the sample cannot be subsequently separated from the stub without being damaged.

Another known possibility to fix the sample is described in "Orientation mapping of nanostructured materials using transmission Kikuchi diffraction in the electron microscope" by Patrick W. Trimby; Ultramicroscopy 120 (2012) 16-24. The paper shows a sample holder in form of a vice with a fixed jaw and a moveable jaw, which can be moved towards or away from the fixed jaw. The moveable jaw is connected to a screw. As a disadvantage the relatively massive fixed jaw limits a minimum distance between the surface of the column which is closest to the sample (especially the pole piece of the EM) and the sample. Moreover the jaws and the screw are arranged close to the EBSD detector, which increases shadowing and creation of background electron and X-ray signal.

JPS6148647U discloses a sample holder according to the preamble of claim 1.

J Further sample holders are disclosed in DE 36 28 170 A1, JP 2005 293865 A, and JP S50 24072 A.

The intention of this invention is therefore to provide a sample holder and an electron microscope that feature improved sample handling capabilities and signal quality.

### SUMMARY

In order to solve the above mentioned technical problem, there is provided a sample holder according to claim 1, and an electron microscope according to claim 7.

The sample holder, which is configured to perform Kikuchi diffraction (TKD) measurements, comprises a tip portion and is configured to fix a sample or a sample carrier comprising the sample in a form-locking and/or a force-locking manner at or in the tip portion.

Further, the sample holder comprises a movable or rotatable element, configured to fix the sample or the sample carrier. The sample holder is configured to provide a snap action of the movable or rotatable element between a loading position and a closed position, such that a portion of the rotatable element is slidable along the elastic element, wherein a surface of the portion has a greater radius to an axis of the rotatable element than at least one surface of the rotatable element adjacent to the portion.

As the sample holder comprises a tip portion and the sample or the sample carrier (at which a sample can be arranged) are fitted at or in the tip portion, a practicable solution to fix the sample or the sample carrier at the sample holder was found without risking an unacceptable amount of shadowing, especially when the sample or the sample carrier is positioned at a (very) front end of the tip portion. Preferably the EM is a scanning electron microscope (SEM).

Preferably, a maximum cross-section dimension (diameter) at the (very) front end of the tip portion is less than 15 mm, more preferably less than 10 mm, especially less than 8 mm. This enables a very slim front end of the tip portion, which further enhances usability and quality of measurements.

The sample or the sample carrier are configured to perform TKD measurements and thus are at least partly electron transparent. Therefore they can be prepared as for a use in a transmission electron microscope (TEM). The sample or the sample carrier can have a shape, which is at least partially circular, with a diameter of approximately 3 mm (standard size for TEM grids). In other words, the sample or the sample carrier may have at least at an edge area of the sample or the sample carrier partly the shape of a disc.

Preferably, the tip portion of the sample holder has a cut-out, which extends from a front end of the tip portion backwards. Thereby an opening of the sample holder, which enables the sample (which can be on the sample carrier) to be accessible to an electron beam of the EM and detection of transmitted electrons, extends to the front end of the tip portion. Thus the tip portion does not cover the sample or the sample carrier at the front end of the tip portion. Due to this "open design" combined TKD and EDS (energy dispersive X-ray spectroscopy) measurements are possible, because the tip portion is not positioned between the sample and an EDS detector or an EBSD detector.

Preferably, the sample holder comprises a connecting member, more preferably a pin stub, which is configured for being connected to a stage of the EM. This makes the sample holder compatible to stages of EMs.

More preferably, the sample holder comprises a pin stub, which is configured for being stuck into a stage of the EM, and the sample holder has a contact plane, which is configured to receive the sample or the sample carrier, wherein an angle between a centre axis of the pin stub and the contact plane is greater than 90 ° and less than 180 °. This enables to compensate a tilt-angle of a tilted stage of the EM. By tilting the stage, a collision between the stage and a detector of the EM is prevented.

Preferably, the tip portion of the sample holder has a tapered shape. This enables a main body of the sample holder to be relatively massive compared to its relatively slim tip portion. Thus, the main body can have a user-friendly shape while preventing shadowing due to its relatively slim tip portion. More preferably, the tapered shape is located at a side of the tip portion facing away from the connecting member. This enables to reduce a minimum working distance between the sample and the surface of a column (comprising the electron lenses of the EM) of the EM which is closest to the sample. This surface may be provided by a pole piece of an electrode lens of the EM. The reduced minimum working distance improves a resolution of the EM. More preferably, the sample holder is configured to enable a minimum working distance of less than 5 mm, preferably less than 4 mm, more preferably less than 3.5 mm. A preferred working distance is between 6 and 3 mm. According to another preferred embodiment, the tapered shape is located at a side of the tip portion where the connecting member is arranged. This prevents shadowing of an EBSD detector of the EM.

According to another embodiment of the invention, the sample holder comprises a seat, which is configured to hold the sample or the sample carrier in all but one translational directions in the form-locking manner. The seat can comprise or be a recess that extends from a surface of the tip portion (preferably from a top surface of the tip portion) into the sample holder. Due to the seat, the sample or the sample carrier can be placed at or inside the sample holder without a risk of sliding of the sample holder.

Preferably, the seat has a shape, such that a circular sample or a circular sample holder protrudes from the tip portion at a front end of the tip portion. In other words, a sample or sample holder, which may be formed like a disc (at least at its edge area along its circumference) is fixed inside the seat such that a portion of its circumference extends out of the tip portion. This results in a minimized amount of shadowing in a space between an area of emitted x-rays (that emit from a surface of the sample facing an electrode lens of the EM) and an area of transmitted electrons (that transmit through the sample and emit from the surface that faces away from the electrode lens).

Preferably, the movable or rotatable element is configured to clamp the sample or the sample carrier. This prevents any movement of the sample or the sample carrier relative to the sample holder in a form-locking and/or force-locking manner. The rotatable element can be a hinged lever. Preferably the movable or rotatable element is configured to cover the sample or the sample carrier at a side that faces away from the front end of the tip portion only. Thus it does not cover neither the area of interest on the sample (usually the center of the sample or the sample carrier) nor the area at the sample or sample carrier front end. This prevents shadowing while performing combined TKD and EDS measurements.

According to a preferred embodiment, the movable or rotatable element is configured to fix the sample or the sample carrier in the remaining translational direction, which is not fixed by the seat. Therefore the sample or the sample carrier is fixed in all directions. Preferably the element fixes the sample or the sample carrier in a form-locking manner. Preferably the element is configured to press the sample into the seat. This eliminates possible play between the sample or the sample holder and the seat.

Preferably, the sample holder comprises an elastic element, preferably a spring, configured to actuate the movable or rotatable element. Thereby an embodiment was found, which can be handled easily and without using a screw.

Since the sample holder is configured to provide a snap action of the movable or rotatable element between a loading position and a closed position, the movable or rotatable element comprises two energetic stable positions, wherein the loading position enables the sample holder to receive the sample or the sample holder at its predetermined position. When the movable or rotatable element is in the closed position, the sample or the sample carrier is locked in or on the sample holder. Between these two positions the movable or rotatable element performs a snap action, which means, that if the movable or rotatable element is closed to a certain amount, it closes itself completely until the closed position is reached. If the movable or rotatable element is opened to a certain amount, it can open itself completely until the loading position is reached.

When the rotatable element is rotated, a snap action is created when the portion glides along the elastic element. When the sample holder is in a closed position and the elastic element still pushes the lever via the portion, the lever is pressed toward a stop (which can be the sample or the sample holder).

Moreover an electron microscope (EM) comprising the sample holder of any one of the previous claims is provided, wherein the EM is configured to perform transmission Kikuchi diffraction (TKD) measurements. Preferably the electron microscope is a scanning electron microscope (SEM). The EM and the SEM are characterised by their enhanced usability and their enhanced quality of measurements. The enhanced quality of measurements is realized by a maximized signal quality due to an optimum sample-detector geometry. A spatial resolution in TKD mode is improved by an order of magnitude compared to (conventional) EBSD.

Preferably, the EM comprises an EBSD (electron backscatter diffraction) detector, an EDS (energy dispersive X-ray spectroscopy) detector and/or an imaging detector, wherein the EM is configured to perform EDS measurements with the EDS detector, and/or to take images with the imaging detector in the same configuration as TKD measurements are performed with the EBSD detector. Thus the positions of the sample, the EBSD detector, the EDS detector and/or the imaging detector do not have to be changed (to do the above mentioned).

More preferably, the imaging detector is an in-column imaging detector. The imaging detector inside the column of the EM enables high magnified images. More precisely, the in-column imaging detector may be arranged inside a pole piece of an electron lens and/or between electron lenses of the column. In-column imaging detectors use secondary electrons (SE) and therefore may me named in-column SE detectors. Another known term would be in-lens SE detector. In-column detectors provide best imaging resolution, which is important for TKD measurements. To use the in-column detector the sample should to be close enough to the pole piece, e.g. at a working distance (WD) of 6 to 3 mm, which is possible due to the sample holder according to the invention.

Further aspects of the invention can be learned from the claims and the description.

### DESCRIPTION OF THE DRAWINGS

- Figure 1: A slanted view of a sample holder in a loading position without a sample;
- Figure 2: A slanted view of the sample holder in a closed position carrying a sample;
- Figure 3: Another slanted view of the sample holder in the closed position;
- Figure 4: A partly transparent lateral view of the sample holder in the closed position;
- Figure 5: A top view of the tip portion of the sample holder;
- Figure 6: Another top view of the tip portion of the sample holder;
- Figure 7: A partial view of an electron microscope (EM); and
- Figure 8: An area of emitted x-rays and an area of transmitted electrons.

### DETAILED DESCRIPTION OF THE INVENTION

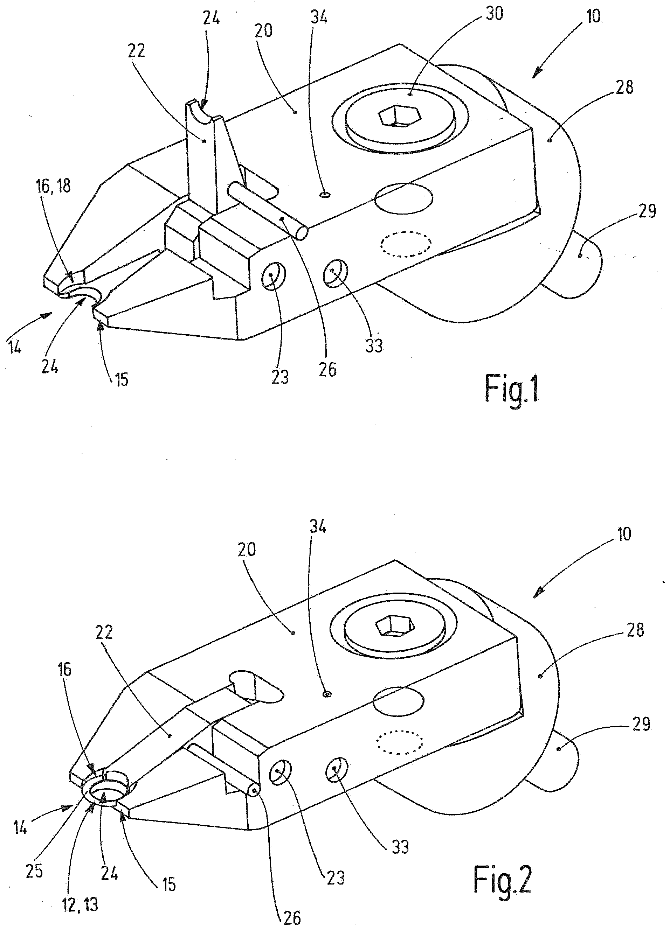

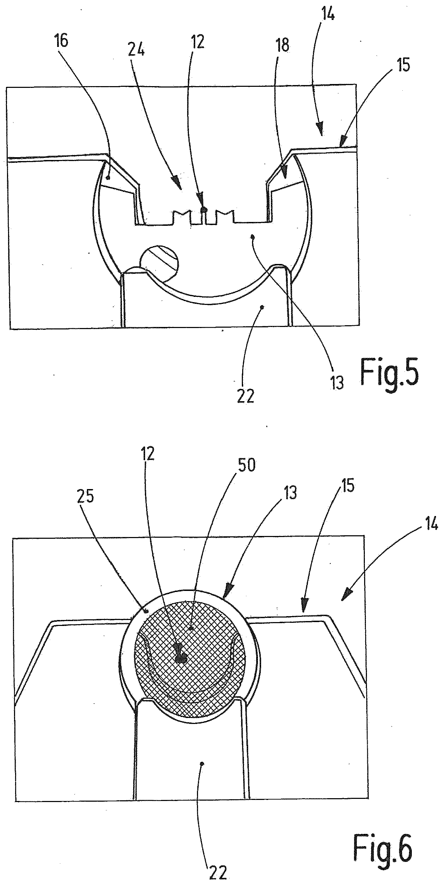

Figures 1 and 2 show a sample holder 10 for positioning a sample 12 or a sample carrier 13 (see figures 5 and 6) inside an electron microscope (EM), which is configured to perform transmission Kikuchi diffraction (TKD) measurements according to a preferred embodiment of the invention in a slanted view from above. Figure 1 shows the sample holder 10 in a loading position (an opened position), while figure 2 shows the sample holder 10 in a closed position (a loaded position).

The sample 12 and the sample carrier 13 are configured to perform TKD. They may be prepared as for a use in a transmission electron microscope (TEM) and thus may be at least partly electron transparent. Normally the sample 12 or the sample carrier has an at least partially circular (disc-like) shape with a diameter of approximately 3 mm.

The sample holder 10 comprises a tip portion 14 and is configured to fix the sample 12 or the sample carrier in a form-locking and/or force-locking manner at or in the tip portion 14. The sample holder 10 may comprise a seat 16, which may form a contact plane 18 to receive the sample 12 or the sample carrier 13. The seat 16 is configured to hold the sample 12 or the sample carrier 13 in all but one translational directions in a form-locking manner. As shown in figure 1 the seat 16 may be a cavity in a main body 20 of the sample holder 10 in which the sample 12 or the sample carrier 13 may be inserted from above. The seat 16 may have a shape, such that a circular sample 12 or a sample carrier 13 protrudes from the tip portion 14, as can be seen in figure 2.

Moreover the sample holder 10 comprises a movable or (as shown in the example) a rotatable element 22, which may be a hinged lever, and is configured to fix the sample 12 or the sample carrier 13. The rotatable element 22 may be mounted as to rotate around an axis 23 of the sample holder 10, which is mounted in the main body 20. The element 22 may be configured to fix the sample 12 or the sample carrier 13 in the remaining translational direction. Moreover the element 22 may clamp the sample 12 or the sample carrier 13, such that a play is eliminated.

The tip portion 14 may have a cut-out 24 that extends from a front end 15 of the tip portion 14 backwards, such that the sample 12 or the sample carrier 13 is covered only at its edge areas 25 that are laterally and backwardly directed, when the movable or rotatable element 22 is in the closed position.

The sample holder 10 may comprise a handle 26, which is connected to element 22 and enables to open or to close the element 22 more easily.

The main body 20 may be connected to a connecting member 28 of the sample holder 10. The main body 20 and the connecting member 28 may be connected by a screw 30. The connecting member 28 is configured for being connected to a stage of an EM. Moreover, the connecting member 28 may be or comprise a pin stub 29, which may be stuck into the stage.

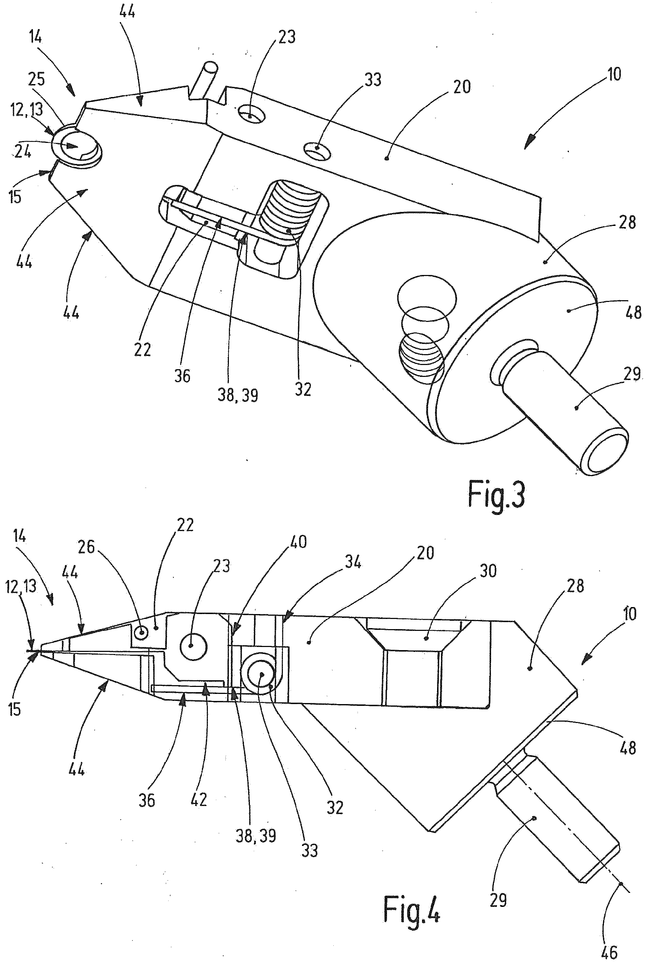

In figures 3 and 4 surplus details of the sample holder 10 can be seen. Figure 3 shows the sample holder 10 in a slanted view from below. Figure 4 shows the sample holder 10 in a lateral view, wherein the main body 20 is shown partly transparent.

The sample holder 10 is configured to provide a snap action of the movable or rotatable element 22 between a loading position (according to figure 1) and a closed position (according to figure 2). Therefore and/or to fix the sample 12 or the sample carrier 13, the sample holder 10 may comprise an elastic element 32, which may be a spring 32. In the shown example the elastic element 32 is a torsion spring. The elastic element may be mounted rotatably on a shaft 33 of the sample holder 10, which is mounted in the main body 20. The elastic element 32 may have a fixed portion 34, which can be fixed to the main body 20, e. g. can be stuck into a hole of the main body 20. In addition, the elastic element 32 has a movable portion 36. Moreover the sample holder 10 is configured, such that a portion 38 of the lever 22 can slide along the elastic element 32 (along its movable portion 36). The portion 38 may be arranged between an opening surface 40 and a closing surface 42 of the lever 22. The portion 38 enlarges a radius between a centre of the axis 23 and the surface of the lever 22 (especially of the portion 38) compared to a radius between the centre of the axis 23 and the adjacent surfaces 40, 42. In more detail the radius is at its peak at an edge 39 of the portion 38.

An angle between a centre axis 46 of the pin stub 29 and the contact plane 18 may be greater than 90° and less than 180°. In other words a contact plane 48, which is configured to rest on the stage of the EM, is tilted away from the contact plane 18. The sample holder preferably has an angle between the centre axis 46 of the pin stub 29 and the contact plane 18 (a pre-tilt) of 135°. For some SEMs with very small airlocks it might be necessary to reduce the angle so that they can go through such small airlocks.

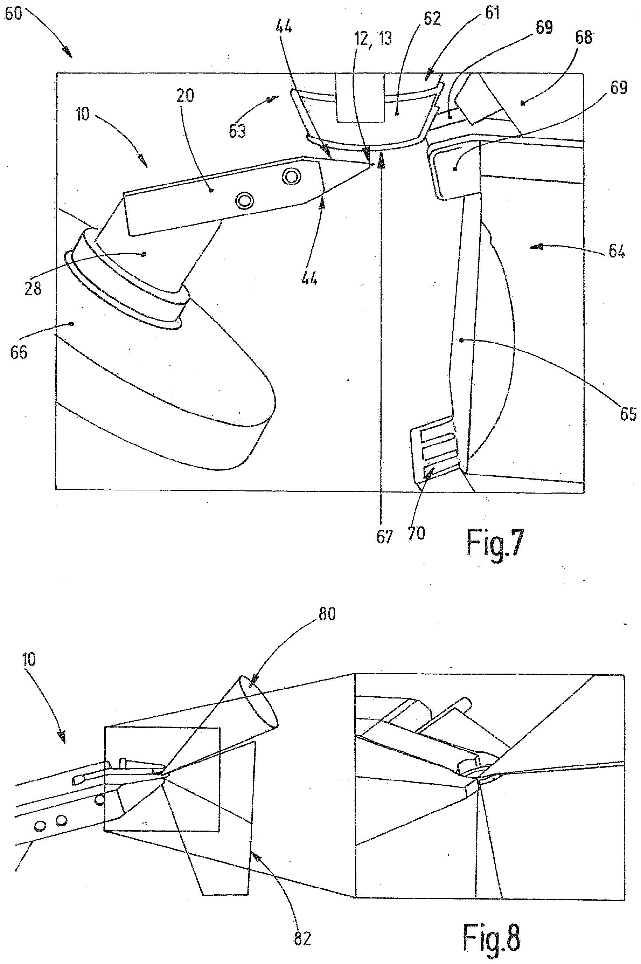

The tip portion 14 of the sample holder 10 may have a tapered shape 44. The tapered shape 44 enables the sample holder 10 to be relatively slim at its front end of the tip portion 14. The tapered shape 44 at the side facing the pin stub (at the side below the sample 12 or the sample carrier 13 / at the same side with the transmitted signal) reduces shadowing while performing TKD measurements, while the tapered shape 44 at the side that faces away from the pin stub (at the top part) enables reducing a working distance (WD) between the sample 12 and the surface of a column 63 (comprising electron lenses 61 of the EM) which is closest to the sample 12. In the example shown in Figure 7 the working distance is measured between the sample 61 and the pole piece 62. The tapered shape 44 at both lateral sides improves the handling of the sample holder 10.

Figures 5 and 6 show the tip portion 14 of the sample holder 10 in a top view in more detail. Figures 5 and 6 both show sample carriers 13, wherein the sample carrier 13 of figure 5 is of a standard grid type (e. g. for holding Focussed Ion Beam (FIB) prepared thin samples 12), while the sample carrier 13 of figure 6 comprises a copper-grid 50 (e. g. containing nanoparticles as a sample 12). The sample 12 is attached to an edge of the standard grid type sample carrier 13 or on the copper grid 50.

The seat 16 fixes the sample 12 or the sample carrier 13 in a form-locking manner in all but one directions. In figures 5 and 6 the direction that is not fixed extends perpendicular to and from the image plane. In this direction the sample 12 or the sample carrier 13 is fixed by the element 22. The sample 12 or the sample carrier 13 is seated on the contact plane 18, which is defined by the seat 16 (and is parallel to the image plane). In the directions along the contact plane 18, the seat 16 fixes the sample 12 or the sample carrier 13 due to its shape that surrounds the sample 12 or the sample carrier 13 partly. As can also be seen in figure 1, the seat 16 may have a shape of at least one segment of a circle, especially two segments of a circle that flank the sample 12 or the sample carrier 13. Moreover the cut-out 24 extends from the front end 15 of the tip portion 14 into the seat 16.

Figure 7 shows a partial view of an electron microscope (EM) 60 according to a preferred embodiment of the invention, which is a scanning electron microscope (SEM). The EM 60 is configured to perform transmission Kikuchi diffraction (TKD) measurements. A pole piece 62, which is part of an electron lens 61 of the EM 60 is arranged at a column 63 (only a part of the column 63 is shown) of the EM 60. Moreover the EM 60 comprises the sample holder 10 and an EBSD detector 64, which may comprise a phosphor screen 65. A stage 66 of the EM 60 is tilted away from the EBSD detector 64, which enables very low sample to detector distances (e g. about 8 mm) between the EBSD detector 64 and the sample 12, without a risk of colliding with the stage 66. Moreover the EM 60 may comprise an EDS (energy dispersive X-ray spectroscopy) detector 68. Furthermore the EM 60 may comprise an imaging detector 67 which may be an in-column imaging detector 67 situated between the electron lenses 61 of the EM 60, thus inside the column 63 (the imaging detector 67 can not be seen in the figure - the arrow points into the direction where the imaging detector 67 is situated). The in-column imaging detector 67 uses secondary electrons (SE) and therefore may be named in-column SE detector. The EM 60 may further comprise BSE (back scatter electrons) diodes 69 and/or forescatter diodes 70 mounted on the EBSD detector 64. The BSE diodes 69 may be two BSE diodes 69 that may be disposed at a distance form each other (there is a free space between the two BSE diodes 69), which allows X-rays to reach the EDS detector 68.

Due to the angle between the centre axis 46 and the contact plane 18 of the sample holder 10, the contact plane 18 may be horizontally or tilted away from the EBSD detector 64. As the sample holder 10 is positioned at the side of the phosphor screen 65, which is closer to the pole piece 62 (the upper side of the phosphor screen 65), an angle between the surface of the phosphor screen 65 and the contact plane 18 is less than 90 °. This means that the surface of the sample 12 or the sample holder 13 facing away from the pole piece 62 is turned towards the EBSD detector 64.

The EM 60 is configured to perform EDS measurements with the EDS detector, and/or to take images with the imaging detector 67 in the same configuration as TKD measurements are performed.

The function of the sample holder 10 and the electron microscope 60 will be described below:
To mount a sample 12 or a sample carrier 13 the movable or rotatable element 22 is in a loading position, thus the element 22 is turned away from the seat 16. The sample 12 or the sample carrier 13 may be placed into the seat 16 from above and is fixed by the seat 16 in a form-locked manner in all but the upward direction. This prevents the sample 12 or the sample carrier 13 from gliding of the sample holder 10.

To fix the sample 12 or the sample carrier 13 inside the sample holder 10, the element 22 is turned towards the seat 16. This may be done by actuating the handle 26. While the element 22 is in a loading position (according to figure 1), the opening surface 40 of the element 22 faces the movable portion 36 of the elastic element 32. When the rotatable element 22 is turned toward the seat 16, the portion 38 is pressed against the movable portion 36, because the surface of the portion 38 is arranged at a bigger distance to the centre of the axis 23 as the closing surface 40. The elastic element 32 gets tensioned more and more until a turning point or threshold is reached. Upon reaching the threshold, the movable portion 36 of the elastic element 32 turns the rotatable element 22 further to the seat 16. Thereby the element 22 performs a snap action until the closed position is reached. In the closed position according to figures 2 to 7, the portion 38 pushes the sample 12 or the sample carrier 13 against the seat 16. This is realised as the portion 38 is in contact with the elastic element 32, while being arranged at the rotatable element 22 such that a torque is created by the elastic element 32 that turns the rotatable element 22 toward the seat 16.

Inside the EM 60, the sample holder 10 is arranged such that the sample 12 or the sample carrier 13 are in an as short as possible distance to the pole piece 62 (e.g. 3 mm), which is supported by the tapered shape 44 of the tip portion 14. The tapered shape 44 facing the EBSD detector 64 reduces shadowing while performing TKD measurements.

The sample 12 or the sample carrier 13, the column 63 comprising the electron lenses 61 with the pole piece 62, the EBSD detector 64, the EDS detector 68 and/or the imaging detector 67 may be arranged in a way, such that TKD measurements and EDS measurements can be made without changing the position of the sample holder 10, the column 63 comprising the electron lenses 61 with the pole piece 62, the EBSD detector 64 or the EDS detector 68. Moreover the parts of the EM 60 as mentioned above may be arranged such that the imaging detector 67, which may be arranged in the column 63 (comprising the pole piece 62) of the EM 60, can take images without the mentioned parts being moved. Thus all additional measurements can be done and images can be taken in the same configuration as TKD measurements are performed thanks to the design of the sample holder 10.

Figure 8 shows an area 80 of emitted x-rays detected by the EDS detector 68 and an area 82 of transmitted electrons detected by the EBSD detector 64. The cut-out 24, that extends from the front end 15 of the tip portion 14 backwards, prevents masking in a space between the area 80 and the area 82. Only the edge area 25 of the sample 12 or the sample carrier 13 masks the space in between the areas 80, 82. This reduces a necessary space between the EBSD detector 64 and the EDS detector 68 and thus enables the EBSD detector 64 to be placed closer to the sample 12. For example, the area 82 of transmitted electrons detected by the EBSD detector 64 at the phosphor screen 65 may have the shape of a rectangle with side lengths of 34,4 mm and 25,4 mm. This may be realized at a distance of e.g. 13 mm or even less, e.g. 8 mm between the sample 12 and the phosphor screen 65.

The sample holder 10 according to the invention enables to position a very thin and fragile sample 12 at a distance as short as possible from the pole piece 62 of the EM 60, wherein EDS and TKD measurements can be performed under optimal circumstances. The design of the sample holder 10 enables to perform EDS and TKD measurements simultaneously at a relatively short working distance from the pole piece 62 of the EM 60. Moreover, it enables a measurement-geometry that prevents shadowing at the phosphor screen 65 of the EBSD detector (EBSD camera) 64 to a minimum. Moreover, the sample holder 10 enables a comfortable fixation and a perfect protection of the sample 12 or the sample carrier 13.

### REFERENCE NUMBERS

- 10: sample holder
- 12: sample
- 13: sample carrier
- 14: tip portion
- 15: front end of the tip portion
- 16: seat
- 18: contact plane
- 20: main body
- 22: movable or rotatable element
- 23: axis on that the hinged lever is mounted
- 24: cut-out
- 25: edge area
- 26: handle
- 28: connecting member
- 29: pin stub
- 30: screw
- 32: elastic element / spring
- 33: shaft on that the elastic element is mounted
- 34: fixed portion
- 36: movable portion
- 38: portion or the rotatable element
- 39: edge
- 40: opening surface
- 42: closing surface
- 44: tapered shape
- 46: centre axis
- 48: contact plane
- 50: copper-grid
- 60: EM / SEM
- 61: electron lens
- 62: pole piece
- 63: column
- 64: EBSD detector
- 65: phosphor screen
- 66: stage
- 67: imaging detector / in-column imaging detector
- 68: EDS detector
- 69: BSE diodes
- 70: forescatter diodes
- 80: area of emitted x-rays
- 82: area of transmitted electrons

## Claims

1. A sample holder (10) for positioning a sample (12) in an electron microscope (60) configured to perform transmission Kikuchi diffraction TKD measurements, wherein the sample holder comprises a tip portion (14) and is configured to fix a sample (12) or a sample carrier (13) comprising the sample (12) in a form-locking and/or a force-locking manner at or in the tip portion (14), wherein
the sample holder (10) comprises a movable or rotatable element (22), configured to fix the sample (12) or the sample carrier (13), wherein
the sample holder (10) is configured to provide a snap action of the movable or rotatable element (22) between a loading position and a closed position,
**characterized in that**
the sample holder (10) is configured, such that a portion (38) of the rotatable element (22) is slidable along an elastic element (32), wherein a surface of the portion (38) has a greater radius to an axis (23) of the rotatable element (22) than at least one surface (40, 42) of the rotatable element (22) adjacent to the portion (38).

2. The sample holder (10) of claim 1, wherein the tip portion (14) of the sample holder (10) has a cut-out (24), which extends from a front end (15) of the tip portion (14) backwards.

3. The sample holder (10) of any one of the previous claims, wherein the sample holder (10) comprises a seat (16), which is configured to hold the sample (12) or the sample carrier (13) in all but one translational directions in the form-locking manner.

4. The sample holder (10) of claim 3, wherein the seat (16) has a shape such that a circular sample (12) or a circular sample carrier (13) protrudes from the tip portion (14) at a front end (15) of the tip portion (14).

5. The sample holder (10) of any of claims 1 to 4, wherein the movable or rotatable element (22) is configured to clamp the sample (12) or the sample carrier (13).

6. The sample holder (10) of any of claims 1 to 5, wherein the elastic element (32) is configured to actuate the movable or rotatable element (22), and preferably comprises a spring (32).

7. An electron microscope (60) comprising the sample holder (10) of any one of the previous claims, wherein the electron microscope (60) is configured to perform transmission Kikuchi diffraction measurements.

8. The electron microscope (60) of claim 7, wherein the electron microscope is a scanning electron microscope.

9. The electron microscope (60) of claim 8, comprising an EBSD detector, i.e. electron backscatter diffraction detector (64), an EDS detector, i.e. energy dispersive X-ray spectroscopy detector (68) and/or an imaging detector, wherein the electron microscope (60) is configured
- to perform EDS measurements with the EDS detector (68), and/or
- to take images with the imaging detector (67) in the same configuration as TKD measurements are performed with the EBSD detector (64).

10. The electron microscope (60) of claim 9, wherein the imaging detector (67) is an in-column imaging detector (67).

## Patentansprüche

1. Probenhalter (10) zum Positionieren einer Probe (12) in einem Elektronenmikroskop, (60), das dazu ausgestaltet ist, Transmission-Kikuchi-Diffraction-Messungen TKD durchzuführen, wobei der Probenhalter einen Spitzenabschnitt (14) umfasst und dazu ausgestaltet ist, eine Probe (12) oder einen die Probe (12) umfassenden Probenträger (13) formschlüssig und/oder kraftschlüssig an oder in dem Spitzenabschnitt (14) zu befestigen, wobei
der Probenhalter (10) ein bewegliches oder drehbares Element (22) umfasst, das dazu ausgestaltet ist, die Probe (12) oder den Probenträger (13) zu befestigen, wobei
der Probenhalter (10) dazu ausgestaltet ist, eine Schnappfunktion des beweglichen oder drehbaren Elements (22) zwischen einer Beladestellung und einer geschlossenen Stellung vorzusehen,
**dadurch gekennzeichnet, dass**
der Probenhalter (10) derart ausgestaltet ist, dass ein Abschnitt (38) des drehbaren Elements (22) entlang einem elastischen Element (32) verschiebbar ist, wobei eine Oberfläche des Abschnitts (38) einen größeren Radius hin zu einer Achse (23) des drehbaren Elements (22) aufweist als wenigstens eine dem Abschnitt (38) benachbarte Oberfläche (40, 42) des drehbaren Elements (22).

2. Probenhalter (10) nach Anspruch 1, wobei der Spitzenabschnitt (14) des Probenhalters (10) eine Ausnehmung (24) aufweist, die sich von einem vorderen Ende (15) des Spitzenabschnitts (14) nach hinten erstreckt.

3. Probenhalter (10) nach einem der vorangehenden Ansprüche, wobei der Probenhalter (10) eine Aufnahme (16) umfasst, die dazu ausgestaltet ist, die Probe (12) oder den Probenträger (13) in allen außer einer translatorischen Richtung(en) formschlüssig zu halten.

4. Probenhalter (10) nach Anspruch 3, wobei die Aufnahme (16) eine Form derart aufweist, dass eine kreisförmige Probe (12) oder ein kreisförmiger Probenträger (13) an einem vorderen Ende (15) des Spitzenabschnitts (14) von dem Spitzenabschnitt (14) vorsteht.

5. Probenhalter (10) nach einem der Ansprüche 1 bis 4, wobei das bewegliche oder drehbare Element (22) dazu ausgestaltet ist, die Probe (12) oder den Probenträger (13) festzuklemmen.

6. Probenhalter (10) nach einem der Ansprüche 1 bis 5, wobei das elastische Element (32) dazu ausgestaltet ist, das bewegliche oder drehbare Element (22) zu betätigen, und vorzugsweise eine Feder (32) umfasst.

7. Elektronenmikroskop (60), das den Probenhalter (10) nach einem der vorangehenden Ansprüche umfasst, wobei das Elektronenmikroskop (60) dazu ausgestaltet ist, Transmission-Kikuchi-Diffraction-Messungen durchzuführen.

8. Elektronenmikroskop (60) nach Anspruch 7, wobei das Elektronenmikroskop ein Rasterelektronenmikroskop ist.

9. Elektronenmikroskop (60) nach Anspruch 8, das einen EBSD-Detektor, d. h. Elektronenrückstreuungsbeugungsdetektor (64), einen EDS-Detektor, d. h. Detektor für energiedispersive Röntgenspektroskopie (68) und/oder einen bildgebenden Detektor umfasst, wobei das Elektronenmikroskop (60) für Folgendes ausgestaltet ist:
- Durchführen von EDS-Messungen mit dem EDS-Detektor (68) und/oder
- Aufnehmen von Bildern mit dem bildgebenden Detektor (67), und zwar in der gleichen Konfiguration, in der mit dem EBSD-Detektor (64) TKD-Messungen durchgeführt werden.

10. Elektronenmikroskop (60) nach Anspruch 9, wobei der bildgebende Detektor (67) ein in die Säule integrierter bildgebender Detektor (67) ist.

## Revendications

1. Porte-échantillon (10) pour positionner un échantillon (12) dans un microscope électronique EM (60) configuré pour effectuer des mesures de diffraction d'électrons rétrodiffusés TKD, dans lequel le porte-échantillon comprend une portion de pointe (14) et est configuré pour fixer un échantillon (12) ou un support d'échantillon (13) comprenant l'échantillon (12) par liaison de forme et/ou par liaison de force sur ou dans la portion de pointe (14), dans lequel
le porte-échantillon (10) comprend un élément (22) mobile ou rotatif, configuré pour fixer l'échantillon (12) ou le support d'échantillon (13), dans lequel
le porte-échantillon (10) étant configuré pour fournir une action d'encliquetage de l'élément (22) mobile ou rotatif entre une position de chargement et une position fermée,
**caractérisé en ce que**
le porte-échantillon (10) est configuré de telle sorte qu'une portion (38) de l'élément (22) rotatif peut coulisser le long d'un l'élément élastique (32), une surface de la portion (38) ayant un plus grand rayon vers un axe (23) de l'élément (22) rotatif qu'au moins une surface (40, 42) de l'élément (22) rotatif adjacent à la portion (38).

2. Porte-échantillon (10) selon la revendication 1, dans lequel la portion de pointe (14) du porte-échantillon (10) a une découpe (24) qui s'étend vers l'arrière à partir d'une extrémité avant (15) de la portion de pointe (14).

3. Porte-échantillon (10) selon l'une quelconque des revendications précédentes, dans lequel le porte-échantillon (10) comprend un siège (16) qui est configuré pour retenir par liaison de forme l'échantillon (12) ou le support d'échantillon (13) dans toutes les directions de translation sauf une.

4. Porte-échantillon (10) selon la revendication 3, dans lequel le siège (16) a une forme de telle sorte qu'un échantillon (12) circulaire ou un support d'échantillon (13) circulaire fait saillie à partir de la portion de pointe (14) à une extrémité avant (15) de la portion de pointe (14).

5. Porte-échantillon (10) selon l'une quelconque des revendications 1 à 4, dans lequel l'élément (22) mobile ou rotatif est configuré pour serrer l'échantillon (12) ou le support d'échantillon (13).

6. Porte-échantillon (10) selon l'une quelconque des revendications 1 à 5, dans lequel l'élément élastique (32) est configuré pour actionner l'élément (22) mobile ou rotatif, et de préférence comprend un ressort (32).

7. Microscope électronique (60), comprenant le porte-échantillon (10) selon l'une quelconque des revendications précédentes, dans lequel le microscope électronique (60) est configuré pour effectuer des mesures de diffraction d'électrons rétrodiffusés.

8. Microscope électronique (60) selon la revendication 7, dans lequel le microscope électronique est un microscope électronique à balayage.

9. Microscope électronique (60) selon la revendication 8, comprenant un détecteur EBSD, c'est-à-dire un détecteur à diffraction rétrodiffusée des électrons (64), un détecteur EDS, c'est-à-dire un détecteur à spectroscopie à rayons X à dispersion d'énergie (68) et/ou un détecteur pour imagerie, dans lequel le microscope électronique (60) est configuré pour effectuer des mesures de diffraction d'électrons (60) est configuré pour
- effectuer des mesures EDS avec le détecteur EDS (68), et/ou
- prendre des images avec le détecteur pour imagerie (67) dans la même configuration avec laquelle des mesures TKD sont effectuées avec le détecteur EBSD (64).

10. Microscope électronique (60) selon la revendication 9, dans lequel le détecteur pour imagerie (67) est un détecteur pour imagerie (67) en colonne.
